Europäisches Patentamt

European Patent Office

Office européen des brevets

(11) Publication number: **0 098 167**
**B1**

(12) **EUROPEAN PATENT SPECIFICATION**

(45) Date of publication of patent specification: **07.09.88**

(51) Int. Cl.⁴: **H 01 L 27/06**

(21) Application number: **83303769.0**

(22) Date of filing: **29.06.83**

(54) **A field-effect semiconductor device.**

(30) Priority: **30.06.82 JP 113253/82**
**01.07.82 JP 115114/82**

(43) Date of publication of application:
**11.01.84 Bulletin 84/02**

(45) Publication of the grant of the patent:
**07.09.88 Bulletin 88/36**

(84) Designated Contracting States:
**DE FR GB**

(56) References cited:
**US-A-3 986 196**
**MICROWAVE JOURNAL, vol. 24, no. 3, March 1981, pages 39-42, 44,48,50, Dedham, MA, US; D.R. CH'EN et al.: "MMIC linear amplifiers-design and fabrication techniques"**
**IEEE TRANSACTIONS ON MICROWAVE THEORY AND TECHNIQUES, vol.MTT-29, no. 6, June 1981, pages 513-534, IEEE, New York, US; R.A. PUCEL: "Design considerations for monolithic microwave circuits"**

(73) Proprietor: **FUJITSU LIMITED**
**1015, Kamikodanaka Nakahara-ku**
**Kawasaki-shi Kanagawa 211 (JP)**

(72) Inventor: **Yamamura, Shigeyuki**
**22-14, Kamiyabe 5-chome**
**Sagamihara-shi Kanagawa 229 (JP)**
Inventor: **Takeuchi, Yukihiro**
**Haitsu Kawabata 101 980-7, Tokaichiba-cho**
**Midori-ku Yokohama-shi Kanagawa 227 (JP)**

(74) Representative: **Fane, Christopher Robin King et al**
**HASELTINE LAKE & CO. Hazlitt House 28**
**Southampton Buildings Chancery Lane**
**London, WC2A 1AT (GB)**

(56) References cited:
**INTERNATIONAL ELECTRON DEVICES MEETING, 7th-9th December 1981, Washington D.C., pages 676-679, IEEE, New York, US; Y. HIRACHI et al.: "A novel via hole P.H.S. structure in K-band power GaAs FET"**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to an improvement of a field-effect semiconductor device having a capacitor and a field-effect transistor (FET), at least one electrode of the FET being grounded via the capacitor. More particularly, the capacitor is formed by means of a via hole in the semiconductor substrate.

A field-effect semiconductor device generally includes active elements, such as gallium arsenic (GaAs) FETs and diodes, and passive elements, such as capacitors, resistors, inductors, and so forth. For example, when a field-effect semiconductor device employs a self-bias circuit so that the GaAs FET can be driven by a single power supply, a capacitor should be connected between the source electrode of the GaAs FET and the ground, and when the field-effect semiconductor device is a low-pass filter type of matching circuit, capacitors, inductors, and GaAs FETs should be formed in the device. As an active element, a via-hole type of GaAs FET described in detail later is known (see for instance, US—A—3986196). In a conventional via-hole type of GaAs FET, one electrode thereof is directly grounded via a via-hole electrode inserted into the via-hole. Therefore, it is impossible to connect a capacitor between the electrode of the via-hole type of GaAs FET and the ground (described in detail later). Accordingly, the conventional via-hole type of GaAs FET cannot employ a self-bias circuit.

Conventionally, when a field-effect semiconductor device such as self-bias circuit or a matching circuit is formed on a semiconductor chip, passive elements, such as capacitors or resistors, are formed at the surface of the semiconductor chip in such a manner that they have planar structures. That is, each passive element itself requires an area which is not used by the other elements. Therefore, these passive elements occupy a considerable area on the semiconductor chip, thereby inhibiting improvement in the integration degree and causing complex wiring to have bad grounding characteristics.

In the invention, such as claimed, a via-hole type FET is provided with improved integration degree and decreased number of manufacturing steps.

An embodiment of the present invention can provide a field-effect semiconductor device having via holes in a semiconductor substrate, in which passive elements such as capacitors or resistors are formed by using the via holes so as to improve the integration degree.

Another embodiment of the present invention can provide the above-mentioned field-effect semiconductor device having a via-hole type of FET in which a capacitor is formed between an electrode opposite to the via hole of the FET and the ground.

Still another embodiment of the present invention can provide the above-mentioned field-effect semiconductor device in which improved grounding characteristics can be obtained.

Still a further embodiment of the present invention can provide the above-mentioned field-effect semiconductor device in which wirings connected to the passive elements can be simplified or eliminated.

Reference will now be made, by way of example, to the accompanying drawings, wherein:

Figure 1 is a cross-sectional view of a conventional FET;

Fig. 2 is an equivalent circuit diagram of the FET of Fig. 1;

Fig. 3 is a conventional circuit diagram of FET including a self-bias circuit;

Fig. 4A is a cross-sectional view of a field-effect semiconductor device according to a first embodiment of the present invention;

Fig. 4B is an equivalent circuit diagram of the device of Fig. 4A;

Fig. 5A is a cross-sectional view of a field-effect semiconductor device according to a second embodiment of the present invention;

Fig. 5B is an equivalent circuit diagram of the device of Fig. 5A;

Fig. 6A is a cross-sectional view of a field-effect semiconductor device according to a third embodiment of the present invention;

Fig. 6B is an equivalent circuit diagram of the device of Fig. 6A;

Fig. 7A is a cross-sectional view of a field-effect semiconductor device according to a fourth embodiment of the present invention; and

Fig. 7B is an amplifier circuit including an equivalent circuit diagram of the device of Fig. 7A; and

Figs. 8 through 10 illustrate the manufacturing step of a capacitor included in any one of the above embodiments.

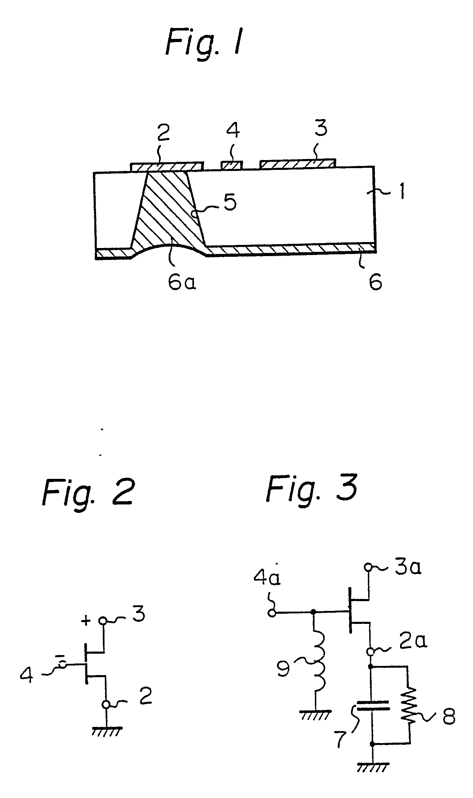

Before describing the preferred embodiments of the present invention, a conventional device, and the problems it involves, is first explained with reference to Figs. 1 through 3.

Figure 1 is a cross-sectional view of a main portion of a conventional via-hole type of FET. In Fig. 1, 1 designates a semiconductor substrate, 2 a source electrode, 3 a drain electrode, 4 a gate electrode, 5 a via hole, 6 a back-surface electrode formed on the back surface of the semiconductor substrate 1, and 6a a via-hole electrode inserted into the via hole 5 so as to connect the source electrode 2 to the back-surface electrode 6.

An equivalent circuit diagram of the device of Fig. 1 is shown in Fig. 2, wherein the same reference numerals designate the same portions as in Fig. 1. To operate the FET of Fig. 2, a positive voltage of, for example, +3 V is applied to the drain electrode 3, a negative voltage of, for example, −2 V is applied to the gate electrode 4, and the source electrode 2 is grounded, i.e., 0 volts are applied to the source electrode 2. Thus, the circuit of Fig. 2 requires two power supplies, i.e., a plus voltage power supply and a minus voltage power supply.

Recently, there has been a great need to operate an FET by a single power supply so as to prevent the destruction of the FET and so. as to decrease the cost thereof.

Figure 3 is a conventional circuit diagram of an FET operated by a single power supply. In Fig. 3, 2a, 3a, and 4a designate a source electrode, a drain electrode, and a gate electrode, respectively, of an FET which is not a viahole type of FET. Reference numerals 7, 8 and 9 designate a capacitor, a resistor, and an inductor, respectively, which form a self-bias circuit. In the self-bias circuit, between the source electrode 2a and the ground, the capacitor 7 and the resistor 8 are connected in parallel. The inductor 9 is connected between the gate electrode 4a and the ground. Thus, with respect to a high-frequency current, the source electrode 2a is almost directly grounded via the capacitor 7. When a positive voltage of, for example, 5 V is applied to the drain electrode 3a, the voltage at the source electrode 2a becomes 2 V, for example, due to a voltage drop across the resistor 8. The gate electrode 4a is grounded with respect to a direct current so that its voltage is 0 volts. Therefore, the voltage at the gate electrode 4a is lower than the voltage at the source electrode 2a by about 2 V. In other words, the gate electrode 4a is self-biased so that the FET of Fig. 3 can be operated by a single power supply (not shown) connected to the drain electrode 3a.

The via-hole type of FET illustrated in Figs. 1 and 2 has an advantage in that the source electrode 2 is easily and surely grounded by the via-hole electrode 6a. However, since the source electrode 2 is directly grounded, a capacitor cannot be connected between the source electrode 2 and the ground. Therefore, the circuit of Fig. 3 including the self-bias circuit cannot be constructed by means of the via-hole type of FET.

When an FET without a via hole is used to form the circuit of Fig. 3, it is easy to form a capacitor in the semiconductor device and to connect the source electrode of the FET to the ground via the capacitor so as to cut a direct current. However, in this case, the capacitor occupies an area which is not used by the other elements on the semiconductor chip and thereby the integration degree is deteriorated. Further, wirings such as those between the source electrode of the FET and the electrode of the capacitor, between the electrode of the capacitor and the ground, and so forth, becomes complex, with the result that the grounding characteristics may be poor.

There are many circuits, such as matching circuits, which require capacitors and FETs. Problems similar to those mentioned above occur in such circuits. The embodiments of the present invention are described.

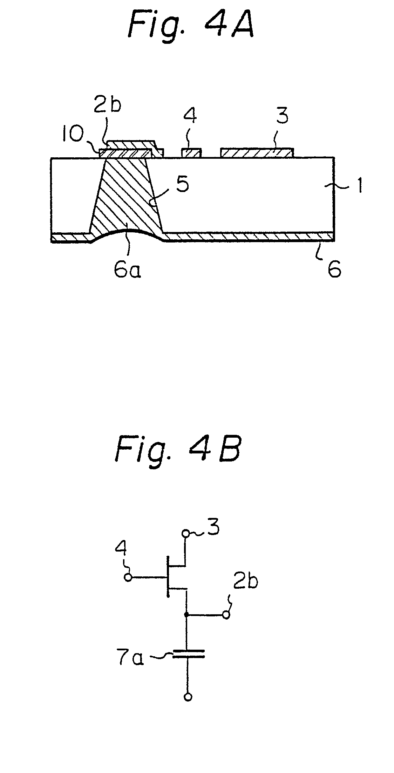

Figure 4A is a cross-sectional view of a field-effect semiconductor device according to a first embodiment of the present invention, and Fig. 4B is an equivalent circuit diagram of the device of Fig. 4A. In these figures and the following figures, the same reference numerals designate the same portions as illustrated in Figs. 1 and 2.

The difference between this embodiment and the conventional device of Fig. 1 is that in Fig. 4A, between the viahole electrode 6a and one part of a source electrode 2b, a dielectric film 10 of, for example, $SiO_2$ is formed. Another part of the source electrode 2b is in contact with the surface of the semiconductor substrate 1. The source electrode 2b, the dielectric film 10, and the via-hole electrode 6a constitute a capacitor 7a as shown in Fig. 4B. When the back-surface electrode 6 is grounded and when the source electrode 2b is grounded via a resistor (not shown), the self-bias circuit shown in Fig. 3 can be easily realized by the device of Fig. 4A. Also, when the source electrode 2b is directly grounded, the circuit of Fig. 2 can be realized.

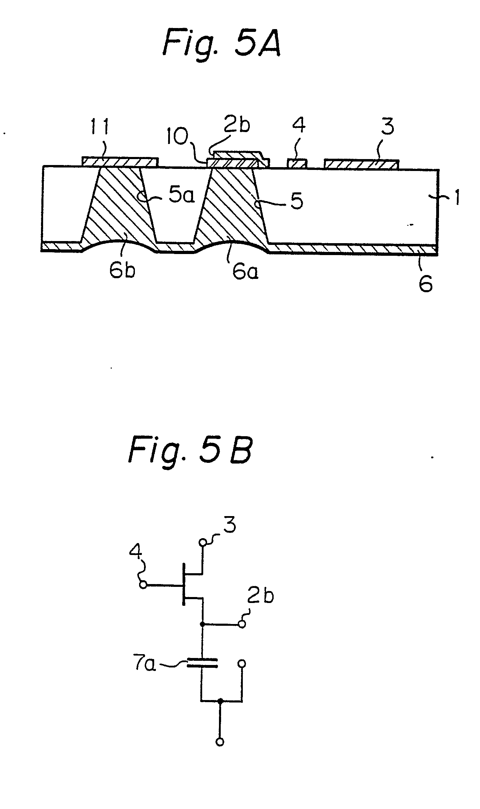

Fig. 5A is a cross-sectional view of a field-effect semiconductor device according to a second embodiment of the present invention, and Fig. 5B is an equivalent circuit diagram of Fig. 5A. The difference between Fig. 4A and Fig. 5A is that, in Fig. 5A, a direct-current grounding electrode 11 is formed near the source electrode 2b and on the surface of the semiconductor substrate 1, and under the electrode 11, another via-hole 5a is formed through the semiconductor substrate 1. In the via hole 5a, a via-hole electrode 6b is buried so as to connect the direct-current grounding electrode 11 to the back-surface electrode 6. When a resistor (not shown) is connected between the source electrode 2b and the direct-current grounding electrode 11, the self-bias circuit shown in Fig. 3 can be realized. Also, when a conductive lead, instead of a resistor, is connected between the source electrode 2b and the direct-current grounding electrode 11, the circuit of Fig. 2 can be realized.

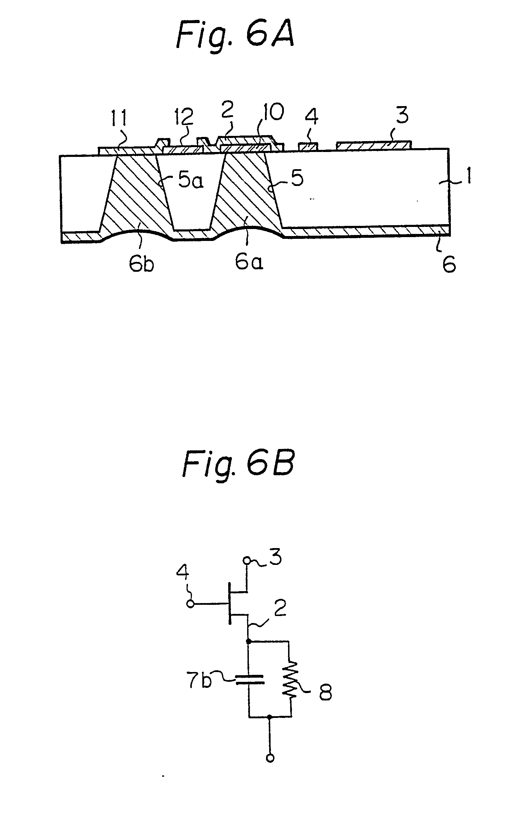

Figure 6A is a cross-sectional view of a field-effect semiconductor device according to a third embodiment of the present invention, and Fig. 6B is an equivalent circuit diagram of Fig. 6A. The difference between Fig. 5A and Fig. 6A is that, in Fig. 6A, a resistive film 12 is formed on the surface of the semiconductor substrate 1 and between the source electrode 2 and the direct-current grounding electrode 11. This resistive film 12 functions as the resistor 8 shown in Fig. 6B. Thus, the self-bias circuit shown in Fig. 3 can be realized.

The description of the foregoing embodiments mainly relates to a via-hole type of FET used so as to be self-biased. The present invention, however, is not restricted to the above embodiments, and various other applications are possible. For example, in accordance with the circuit design, a capacitor may alternatively be formed between a gate electrode or a drain electrode and a via hole of the viahole type FET when the via hole is formed so as to be opposite to the gate electrode or the drain electrode.

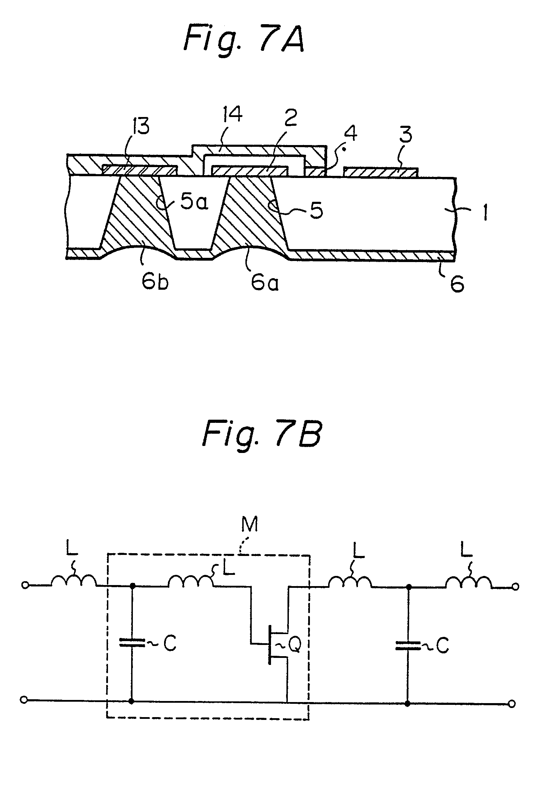

Figure 7A is a cross-sectional view of a low-pass filter type of amplifier circuit device according to a fourth embodiment of the present invention, and Fig. 7B a low-pass filter type of amplifier circuit including an equivalent circuit diagram of the device of Fig. 7A and a matching circuit. In Fig. 7A, part of a low-pass filter type of amplifier circuit device is illustrated. On the surface of the semiconductor substrate 1 and opposite to the second via-hole electrode 6b, a second dielectric film 13 is formed. The gate electrode 4 and the second dielectric film 13 are connected by a conductive layer 14. Thus, as Fig. 7B shows, a capacitor C is formed between the conductive layer 14 and the second via-hole electrode 6b. The conductive layer 14 functions as in inductor L.

In Fig. 7B, a circuit M enclosed by the broken line is an equivalent circuit diagram of the device of Fig. 7A. The circuit of Fig. 7B is a well-known low-pass filter type amplifier circuit including an FET, capacitors C, and inductor L. It will be understood that the series connected two inductors L and one capacitor C connected to these inductors L, constitute a matching circuit, and that all of the elements Q, C and L can be formed so as to have a structure similar to that of the device of Fig. 7A.

In the foregoing embodiments, the dielectric film 10 or 13 on the via-hole electrode 6a or 6b is used to form a capacitor. However, when impurities which supply carriers are included in the dielectric film 10 or 13, the dielectric film acts as a resistor. The resistance value R(Ω) and the capacitance value C(F) are determined by the following well-known equations (1) and (2), respectively:

$$R = \rho \frac{L}{S} \qquad (1)$$

where $\rho$ is the specific resistivity $(\Omega m)$ of the resistor, S is the cross-sectional area $(m^2)$ of the resistor, and L is the length (m) of the resistor

$$C = \varepsilon \frac{S}{d} \qquad (2)$$

where $\varepsilon$ is the dielectric constant of the material between the electrodes of the capacitor, d is the distance between the electrodes of the capacitor and S is the cross-sectional area $(m^2)$ of the electrodes of the capacitor.

In a field-effect semiconductor device, the resistance value and the capacitance value must be accurate. To obtain an accurate resistance or capacitance, the thickness of the dielectric film must be critically controlled, as will be understood from the above equations (1) and (2). It is, however, difficult to accurately control the thickness of the dielectric film by a conventional technique because, after the dielectric film is formed on the semiconductor substrate 1, a via hole is formed by etching from the back surface of the semiconductor substrate, and, at the end of the etching process, the dielectric film may also be etched or part of the semiconductor substrate may remain under the dielectric film.

In order to obtain an accurate capacitance or resistance, according to the present invention, the dielectric film has an etching rate lower than the etching rate of the semiconductor substrate so that the thickness of the dielectric film is accurately predetermined. By this constitution, the etching for forming the via hole is accurately ended at the top surface of the semiconductor substrate. Thus, the resultant resistance or capacitance realized by the dielectric film is very accurate.

As an example, the semiconductor substrate is made of semi-insulating GaAs, the dielectric film is made of aluminum gallium arsenic (AlGaAs) and is formed by molecular beam epitaxy (MBE), and the via hole is etched by reactive sputtering by means of reactive gas such as dichlorodifluoromethane $(CCl_2F_2)$, etc.

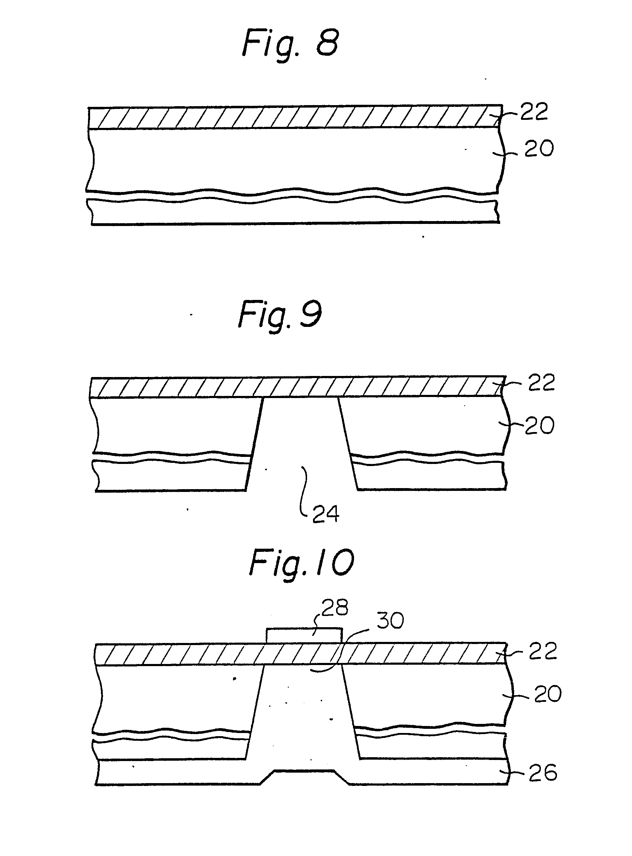

Figures 8 through 10 illustrate the manufacturing steps of a capacitor included in any one of the foregoing illustrated embodiments.

In Fig. 8, on a semi-insulating GaAs substrate 20 having a thickness of about 400 µm, a dielectric film 22 made of semi-insulating AlGaAs, where Al 7s 30% and Ga is 70%, (hereinafter referred to as $Al_{0.3} Ga_{0.7}$ As) is formed by means of metal-organic compound chemical vapor deposition, MBE, and so forth so as to have a desired thickness. The thickness of the dielectric film 22 is determined by the capacitance of the capacitor to be manufactured.

In accordance with the circuit design, an N-type AlGaAs layer (not shown) may be formed under the dielectric film 22.

In Fig. 9, the semi-insulating GaAs substrate 20 is abrased mechanically or chemically from its back surface so that it has a desired thickness of from 10 µm through 300 µm. Then a via hole 24 extending to the back surface of the dielectric film 22 is formed. The step of forming the via hole is carried out by reactive sputtering by using a reactive gas such as $CCl_2F_2$, etc. In this step, since the etching rate of the semi-insulating GaAs substrate 20 is two hundred times higher than the etching rate of the dielectric film 22 made of $Al_{0.3} Ga_{0.7}$ As, only the semi-insulating GaAs substrate 20 is selectively etched.

In Fig. 10, under the semi-insulating GaAs substrate 20, a back-surface electrode 26 is formed by means of a well known platted heat sink technique (PHS). That is, the back-surface electrode 26 is made of gold germanium formed by means of vacuum evaporation so as to extend into the via hole 24, and gold plating is carried out on the surface of the gold germanium. Then, on the dielectric film 22 of semi-insulating $Al_{0.3} Ga_{0.7}$ As, an upper electrode 28 is formed from aluminum (Al), gold An, gold-germanium (AuGe), gold-germanium-nickel (AuGeNi), or other conductive material, by means of sputtering and photo-lithography. Thus, a capacitor according to the present invention is completed.

The upper electrode 28 is connected to a selected source, drain, or gate electrode of a GaAs FET formed in an N-type GaAs active layer (not shown) which is selectively formed on or in the semi-insulating GaAs substrate 20 by means of a well known mesa etching or ion injection method.

The capacitance of the resultant capacitor is determined by the thickness of the dielectric film 22, the area of the surface of the upper electrode 28 opposite to the dielectric film 22, and the area of the upper surface of a via-hole electrode 30 in the via hole 24. Assume that the shape of the portion of the upper electrode 28 in contact with the dielectric film 22 is a square having one side being 50 μm, and that the shape of the portion of the via-hole electrode 30 in contact with the dielectric film 22 is the same as that of the upper electrode 28. In such a case, when a capacitance of about 2.7 PF is to be obtained, the thickness d of the dielectric film 22 is determined by inserting the following numbers into the before-described equation (2):

$$C = 2.7 \, (PF) = 2.7 \times 10^{-12} \, (F)$$
$$\varepsilon = 12.2 \times 8.854 \times 10^{-12} \, (F/m)$$
$$S = 50^2 \, (\mu m^2) = (50 \times 10^{-6})^2 \, (m^2)$$

Then the thickness d can be obtained as:

$$d = \frac{\varepsilon S}{C} = 1{,}000 \times 10^{-10} \, (m) = 1{,}000 \, (A°)$$

In this case, since the thickness of the dielectric film 22 is extremely thin, i.e., 1,000 (A°), it is preferable that the growing speed of a chemical compound such as AlGaAs for forming the dielectric film 22 be relatively slow as to control the thickness as accurately as possible.

When the dielectric film 22 is used as a resistor, a desired resistance can be obtained by introducing impurities of a desired type of conductivity into the dielectric film 22 of AlGaAs. In the before-described equation (1), L is the thickness of the dielectric film 22.

Thus, according to the above-mentioned steps, a capacitor or a resistor can be formed together with a via-hole electrode without adding more steps to the conventional steps.

From the foregoing description of the embodiments, it will be apparent that, according to the present invention, since a large capacitor is formed by a via-hole electrode to be grounded, an electrode selected from among a source, a drain, and a gate electrode of a via-hole type of FET, and a dielectric film formed between the via-hole electrode and the selected electrode, a high-frequency current conducted through the selected electrode is grounded via the capacitor, and a direct current conducted through the selected electrode is not grounded. Accordingly, a field-effect semiconductor device including a passive element such as a self-bias circuit or a matching circuit including passive elements, such as capacitors, can be formed together with via-hole type FETs so that the integration degree of, the grounding characteristics of, and the wirings connected to the passive elements of the field-effect semiconductor device are all improved.

## Claims

1. A field-effect semiconductor device comprising:

a semiconductor substrate (1);

a first via-hole electrode (6a) selectively formed in said semiconductor substrate so as to penetrate from the back surface to the top surface of said semiconductor substrate;

a first dielectric film (10) formed on the surface of said first via-hole electrode;

a first electrode (26) of a field-effect transistor, said first electrode being in contact with said first dielectric film and with said top surface of said semiconductor substrate; and

a back-surface electrode (6) formed on said back surface of said semiconductor substrate, said back-surface electrode being integral with said first via-hole electrode.

2. A field-effect semiconductor device as set forth in claim 1, wherein said first electrode of said field-effect transistor is one selected from among a source electrode, a gate electrode, and a drain electrode.

3. A field-effect semiconductor device as set forth in claim 2, said first electrode, said first dielectric film, and said first via-hole electrode constituting a capacitor.

4. A field-effect semiconductor device as set forth in claim 3, wherein said first electrode is said source electrode of said field-effect transistor.

5. A field-effect semiconductor device as set forth in claim 4, wherein said back-surface electrode is grounded.

6. A field-effect semiconductor device as set forth in claim 4, further comprising:

a second via-hole electrode formed in said semiconductor substrate so as to penetrate from the back surface to the top surface of said semiconductor substrate, said second via-hole electrode being integral with said back-surface electrod; and

a second electrode (11) formed on said top surface of said semiconductor substrate so as to contact said second via-hole electrode.

7. A field-effect semiconductor device as set forth in claim 6, further comprising a resistive film (12) formed between said first electrode (10) and said second (11) electrode on said semiconductor substrate.

8. A field-effect semiconductor device as set forth in claim 1, wherein said first electrode is a gate electrode of said field-effect transistor, further comprising:

a source electrode of said field-effect transistor, formed on said semiconductor substrate;

a second via-hole formed under said source electrode and in said semiconductor substrate so as to penetrate from the back surface to the top surface of said semiconductor substrate;

a second via-hole electrode buried in said second via hole, and second via-hole electrode being integral with said back-surface electrode; and

a conductive layer connected between said gate electrode and said first dielectric film.

9. A field-effect semiconductor device as set forth in claim 8, wherein said conductive layer comprises an inductor.

10. A field-effect semiconductor device as set forth in claim 9, wherein said device constitutes a matching circuit.

11. A field-effect semiconductor device as set forth in claim 3, wherein said semiconductor substrate and said first dielectric film have different etching rates.

12. A field-effect semiconductor device as set forth in claim 6, wherein said semiconductor substrate and said second dielectric film have different etching rates.

13. A field-effect semiconductor device as set forth in claim 7, wherein said resistive film is of a semiconductor material doped with impurity ions so as to form a resistor.

14. An integrated circuit device comprising at least one capacitor, said capacitor comprising:

a semiconductor substrate (1);

a via-hole electrode (5) selectively formed in said semiconductor substrate so as to penetrate from the back surface to the top surface of said semiconductor substrate;

a dielectric film (10) formed on the surface of said via-hole electrode;

an electrode (26) of a field-effect transistor, said electrode being in contact with said dielectric film and with said top surface of said semiconductor substrate; and

a back-surface electrode (6) formed on said back surface of said semiconductor substrate, said back-surface electrode being integral with said via-hole electrode.

**Patentansprüche**

1. Feldeffekt-Halbleitervorrichtung mit:

einem Halbleitersubstrat (1);

einer ersten Durchgangslochelektrode (6a), die wahlweise in dem genannten Halbleitersubstrat so geformt ist, daß sie von der hinteren Oberfläche zu der oberen Oberfläche des genannten Halbleitersubstrats hindurchdringt;

einem ersten dielektrischen Film (10), der auf der Oberfläche der genannten ersten Durchgangslochelektrode gebildet ist;

einer ersten Elektrode (2b) von einem ersten Feldeffekttransistor, welche genannte erste Elektrode mit dem genannten ersten dielektrischen Film und mit der genannten oberen Oberfläche des genannten Halbleitersubstrats in Kontakt ist; und

einer Rück-Oberflächenelektrode (6), die auf der genannten hinteren Oberfläche des genannten Halbleitersubstrats gebildet ist, welche Rück-Oberflächenelektrode einstückig mit der genannten ersten Durchgangslochelektrode ausgebildet ist.

2. Feldeffekt-Halbleitervorrichtung nach Anspruch 1, bei welcher die genannte erste Elektrode des genannten Feldeffekttransistors wahlweise eine Sourceelektrode, eine Gateelektrode oder eine Drainelektrode ist.

3. Feldeffekt-Halbleitervorrichtung nach Anspruch 2, bei welcher die genannte erste Elektrode, der genannte erste dielektrische Film und die erste Durchgangslochelektrode einen Kondensator bilden.

4. Feldeffekt-Halbleitervorrichtung nach Anspruch 3, bei welcher die genannte erste Elektrode eine Sourceelektrode des genannten Feldeffekttransistors ist.

5. Feldeffekt-Halbleitervorrichtung nach Anspruch 4, bei welcher die genannte Rück-Oberflächenelektrode geerdet ist.

6. Feldeffekt-Halbleitervorrichtung nach Anspruch 4, ferner mit:

einer zweiten Durchgangslochelektrode, die in dem genannten Halbleitersubstrat so gebildet ist, daß sie von der hinteren Oberfläche zu der oberen Oberfläche des genannten Halbleitersubstrats hindurchdringt, welche genannte Durchgangslochelektrode einstückig mit der genannten Rück-Oberflächenelektrode ausgebildet ist; und

einer zweiten Elektrode (11), die auf der genannten oberen Oberfläche des genannten Halbleitersubstrats so ausgebildet ist, daß sie mit der genannten zweiten Durchgangslochelektrode kontaktiert.

7. Feldeffekt-Halbleitervorrichtung nach Anspruch 6, ferner mit einem Widerstandsfilm (12), der zwischen der genannten ersten Elektrode (10) und der genannten zweiten Elektrode (11) auf dem genannten Halbleitersubstrat gebildet ist.

8. Feldeffekt-Halbleitervorrichtung nach Anspruch 1, bei der die genannte erste Elektrode eine Gateelektrode des genannten Feldeffekttransistors ist, und die ferner umfaßt:

eine Sourceelektrode des genannten Feldeffekttransistors, der auf dem genannten Halbleitersubstrat gebildet ist;

eine zweites Durchgangsloch, welches unter der genannten Sourceelektrode und in dem genannten Halbleitersubstrat so gebildet ist, daß es von der hinteren Oberfläche zu der oberen Oberfläche des genannten Halbleitersubstrats hindurchdringt;

eine zweite Durchgangslochelektrode, die in dem genannten zweiten Durchgangsloch vergraben ist, und die einstückig mit der Rück-Oberflächenelektrode verbunden ist; und

eine leitende Schicht, die zwischen der genannten Gateelektrode und dem genannten ersten dielektrischen Film verbunden ist.

9. Feldeffekt-Halbleitervorrichtung nach Anspruch 8, bei welcher die genannte Schicht einen Induktor umfaßt.

10. Feldeffekt-Halbleitervorrichtung nach Anspruch 9, bei der die genannte Vorrichtung eine Anpassungsschaltung ist.

11. Feldeffekt-Halbleitervorrichtung nach Anspruch 3, bei der das genannte Halbleitersubstrat und der genannte erste dielektrische Film verschiedene Ätzraten haben.

12. Feldeffekt-Halbleitervorrichtung nach Anspruch 6, bei der das genannte Halbleitersubstrat und der genannte zweite dielektrische Film verschiedene Ätzraten haben.

13. Feldeffekt-Halbleitervorrichtung nach Anspruch 7, bei der der genannte Widerstandsfilm aus Halbleitermaterial ist, welches mit Verunreinigungsionen dotiert ist, um so einen Widerstand zu formen.

14. Integrierte Schaltungsvorrichtung mit wenigstens einem Kondensator, welcher Kondensator umfaßt:

eine Halbleitersubstrat (1);

eine Durchgangslochelektrode (5), die wahlweise in dem genannten Halbleitersubstrat so ausgebildet ist, daß sie von der hinteren Oberfläche zu der oberen Oberfläche des genannten Halbleitersubstrats hindurchdringt;

einen dielektrischen Film (10), der auf der Oberfläche der genannten Durchgangslochelektrode gebildet ist;

eine Elektrode (2b) von einem Feldeffekttransistor, welche Elektrode mit dem genannten dielektrischen Film und mit der genannten oberen Oberfläche des genannten Halbleitersubstrats in Kontakt ist; und

einer Rück-Oberflächenelektrode (6), die auf der genannten hinteren Oberfläche des genannten Halbleitersubstrats gebildet ist, welche genannte Rück-Oberflächenelektrode einstückig mit der genannten Durchgangslochelektrode ausgebildet ist.

## Revendications

1. Dispositif semiconducteur à effet de champ comprenant:

un substrat semiconducteur (1);

une première électrode de trou passant (6a) sélectivement formée dans ledit substrat semiconducteur de manière à pénétrer depuis la surface postérieure jusqu'à la surface supérieure dudit substrat semiconducteur;

une première pellicule diélectrique (10) formée à la surface de ladite première électrode de trou passant;

une première électrode (2b) d'un transistor à effet de champ, ladite première électrode étant en contact avec ladite première pellicule diélectrique et avec ladite surface supérieure dudit substrat semiconducteur; et

une électrode de surface postérieure (6) formée sur ladite surface postérieure dudit substrat semiconducteur, ladite électrode de surface postérieure étant intégrée avec ladite première électrode de trou passant.

2. Dispositif semiconducteur à effet de champ selon la revendication 1, où ladite première électrode dudit transistor à effet de champ est une électrode choisie entre une électrode de source, une électrode de grille et une électrode de drain.

3. Dispositif semiconducteur à effet de champ selon la revendication 2, où ladite première électrode, ladite première pellicule diélectrique et ladite première électrode de trou passant constituent un condensateur.

4. Dispositif semiconducteur à effet de champ selon la revendication 3, où ladite première électrode est l'électrode de source dudit transistor à effet de champ.

5. Dispositif semiconducteur à effet de champ selon la revendication 4, où ladite électrode de surface postérieure est mise à la terre.

6. Dispositif semiconducteur à effet de champ selon la revendication 4, comprenant en outre:

une deuxième électrode de trou passant formée dans ledit substrat semiconducteur de manière à pénétrer depuis la surface postérieure jusqu'à la surface supérieure dudit substrat semiconducteur, ladite deuxième électrode de trou passant étant intégrée avec ladite électrode de surface postérieure; et

une deuxième électrode (11) formée sur ladite surface supérieure dudit substrat semiconducteur de manière à être en contact avec ladite deuxième électrode de trou passant.

7. Dispositif semiconducteur à effet de champ selon la revendication 6, comprenant en outre une pellicule résistive (12) formée entre ladite première électrode (10) et ladite deuxième électrode (11) sur ledit substrat semiconducteur.

8. Dispositif semiconducteur à effet de champ selon la revendication 1, où ladite première électrode est une électrode de grille dudit transistor à effet de champ, comprenant en outre:

une électrode de source dudit transistor à effet de champ, formée sur ledit substrat semiconducteur;

un deuxième trou passant formé sous ladite électrode de source et dans ledit substrat semiconducteur de manière à pénétrer depuis la surface postérieure jusqu'à la surface supérieure dudit substrat semiconducteur,

une deuxième électrode de trou passant enterrée dans ledit deuxième trou passant, la deuxième électrode de trou passant étant intégrée avec ladite électrode de surface postérieure; et

une couche conductrice connectée entre ladite électrode de grille et ladite première pellicule diélectrique.

9. Dispositif semiconducteur à effet de champ selon la revendication 8, où ladite couche conductrice comporte une inductance.

10. Dispositif semiconducteur à effet de champ selon la revendication 9, où ledit dispositif constitue un circuit d'adaptation.

11. Dispositif semiconducteur à effet de champ selon la revendication 3, où ledit substrat semiconducteur et ladite première pellicule diélectrique possèdent des vitesses d'incision différentes.

12. Dispositif semiconducteur à effet de champ selon la revendication 6, où ledit substrat semiconducteur et ladite deuxième pellicule diélectrique ont des vitesses d'incision différentes.

13. Dispositif semiconducteur à effet de champ selon la revendication 7, où ladite pellicule résistive est faite d'une matière semiconductrice dopée à l'aide d'ions d'impureté de manière à former une résistance.

14. Dispositif à circuit intégré comprenant au moins un condensateur, ledit condensateur comprenant:

un substrat semiconducteur (1);

une électrode de trou passant (5) sélectivement formée dans ledit substrat semiconducteur de manière à pénétrer depuis la surface postérieure jusqu'à la surface supérieure dudit substrat semiconducteur;

une pellicule diélectrique (10) formée à la surface de ladite électrode de trou passant;

une électrode (2b) d'un transistor à effet de champ, ladite électrode étant en contact avec ladite pellicule diélectrique et avec ladite surface supérieure dudit substrat semiconducteur; et

une électrode de surface postérieure (6) formée sur ladite surface postérieure dudit substrat semiconducteur, ladite électrode de surface postérieure étant intégrée avec ladite électrode de trou passant.

# Fig. I

# Fig. 2

# Fig. 3

1

# Fig. 4A

# Fig. 4B

## Fig. 5A

## Fig. 5 B

## Fig. 6A

## Fig. 6B

# Fig. 7A

# Fig. 7B

## Fig. 8

## Fig. 9

## Fig. 10